# FASCICULE DE BREVET EUROPEEN

(11) **EP 4 325 573 B1**
(45) Date de publication et mention de la délivrance du brevet: **12.02.2025**
(21) Numéro de dépôt: 23190585.2
(22) Date de dépôt: 09.08.2023
(51) Int. Cl.: H01L 27/146, H04N 25/59, H04N 25/77, H04N 25/79

(54) **DOUBLE CTIA POUR PHOTODIODE NON CLAMPÉE**
DOPPEL-CTIA FÜR NICHT-KLEMMBARE PHOTODIODE
DUAL CTIA FOR NON-CLAMPED PHOTODIODE

(30) Priorité: 17.08.2022 FR 2208346
(43) Date de publication de la demande: 21.02.2024
(73) Titulaire: Commissariat à l'Energie Atomique et aux Energies Alternatives, 75015 Paris (FR)
(72) Inventeur: AYEL, François, 38054 GRENOBLE CEDEX 09 (FR); SAXOD, Oliver, 38054 GRENOBLE CEDEX 09 (FR)
(74) Mandataire: Brevalex

(56) Documents cités:
- US-A1- 2019 237 499
- US-B2- 9 356 067

## Description

### DOMAINE TECHNIQUE

La présente demande concerne le domaine des capteurs d'image, en particulier celui des capteurs dotés de pixels à illumination par la face arrière, et plus précisément ceux à photodiodes pincées (« clamped » selon la terminologie anglo-saxonne) et munis d'une structure de grille de transfert de charges.

### ÉTAT DE LA TECHNIQUE ANTÉRIEURE

Un capteur d'image comprend typiquement une pluralité de pixels, munis chacun d'une zone photosensible formée dans un substrat.

Dans un capteur d'image à illumination par la face arrière ou BSI (pour « BackSide Illumination »), il y a une phase de photo-conversion ou d'intégration pendant laquelle la face arrière du substrat est illuminée et des paires électron-trou sont générées et des porteurs, soit des électrons photo-générés, soit des trous photo-générés, s'accumulent dans la zone photosensible.

Un exemple de pixel à illumination par la face arrière est présenté par exemple dans le document US 2018/061875A1.

Dans cet exemple, on place le substrat dans un régime de déplétion comparable à une photodiode pincée. Le pincement est réalisé par la couche d'inversion de tranchées capacitives profondes d'isolation CDTI (« Capacitive Deep Trench Isolation ») polarisées. Le document US 2019/237499 A1 est un autre exemple de l'art antérieure.

Lors d'une phase de lecture, un dispositif de transfert de charges est commandé pour transférer les charges photo-générées qui se sont accumulées dans la zone photosensible vers une zone semi-conductrice dopée de collecte de charges reliée à un nœud de détection (« Sense Node » selon la terminologie anglo-saxonne).

Dans les capteurs comprenant des pixels destinés à recevoir un éclairage par la face arrière du substrat, pour chaque pixel, la zone de collecte de charges et le nœud de détection sont disposés au niveau de la face avant du substrat.

Une grille de transfert verticale peut être prévue pour permettre de commander le transfert de charges contenues dans la zone photosensible vers la zone de collecte et le nœud de lecture. Cette grille est typiquement disposée autour de la zone de collecte.

L'application d'un potentiel adéquat sur la grille de transfert permet de former une barrière de potentiel dans une région située à l'intérieur de la grille de transfert verticale, entre la zone photosensible et la zone de collecte. La présence de cette barrière de potentiel permet, au cours d'une phase d'exposition, de bloquer un transfert de porteurs photo-générés depuis la zone photosensible vers la zone de collecte. Cette barrière de potentiel résulte de la présence, le long de parois latérales d'une tranchée dans laquelle la grille de transfert est formée, d'une couche d'inversion attirant les porteurs de type opposé au substrat.

Lors d'une illumination, la diode se remplit de charges. Si le potentiel interne de la diode, qui évolue en fonction de la quantité de charges accumulée, est supérieur au potentiel de la barrière d'une portion délimitée et entourée par la ou les grilles de transfert, des charges vont se déplacer vers le nœud de détection.

Il existe un besoin de pouvoir détecter ce phénomène que l'on qualifie de « débordement » de charges et en particulier de pouvoir le détecter rapidement.

### EXPOSÉ DE L'INVENTION

Selon un aspect, l'invention concerne un capteur d'images comprenant un ou plusieurs pixels, chaque pixel comportant :
- une zone photosensible formée dans un substrat semi-conducteur ;
- une tranchée d'isolation périphérique s'étendant verticalement dans le substrat semi-conducteur et délimitant latéralement la zone photosensible ;
- un nœud de détection comportant une zone de collecte de charges photo-générées agencée au niveau d'une face supérieure du substrat, la zone de collecte de charges étant dopée et présentant un premier type de conductivité, en particulier de type P ;

- une grille de transfert de charges s'étendant verticalement dans le substrat semi-conducteur autour de la zone de collecte de charges ;
- un caisson intercalé entre la tranchée d'isolation périphérique et la grille de transfert verticale, et agencé autour du nœud de détection, le caisson étant dopé et présentant un deuxième type de conductivité, opposé au premier type de conductivité, en particulier de type N, la zone photosensible étant formée d'une première région dopée qui est du premier type de conductivité, en particulier de type P, et qui s'étend sous la zone de collecte de charges et sous le caisson et forme une diode avec le caisson,
le capteur étant muni d'un circuit de détection de débordement de charges configuré pour, lors d'une opération de « détection de débordement de charges » lors de laquelle une polarisation de la grille de transfert est appliquée de sorte à former une barrière de potentiel puis maintenue et consécutivement à une illumination de la zone photosensible durant l'opération entrainant un transfert de charges photo-générées de la zone photosensible vers le nœud de détection et une variation de potentiel à ce nœud de détection, détecter cette variation de potentiel.

Selon un mode de réalisation, l'invention concerne un capteur d'images comprenant un ou plusieurs pixels, chaque pixel comportant :
- une zone photosensible formée dans un substrat semi-conducteur ;
- une tranchée d'isolation périphérique s'étendant verticalement dans le substrat semi-conducteur et délimitant latéralement la zone photosensible ;
- un nœud de détection comportant une zone de collecte de charges photo-générées agencée au niveau d'une face supérieure du substrat, la zone de collecte de charges étant dopée et présentant un premier type de conductivité, en particulier de type P ;
- une grille de transfert de charges s'étendant verticalement dans le substrat semi-conducteur autour de la zone de collecte de charges ;
- un caisson intercalé entre la tranchée d'isolation périphérique et la grille de transfert verticale, et agencé autour du nœud de détection, le caisson étant dopé et présentant un deuxième type de conductivité, opposé au premier type de conductivité, en particulier de type N, la zone photosensible étant formée d'une première région dopée qui est du premier type de conductivité, en particulier de type P, et qui s'étend sous la zone de collecte de charges et sous le caisson et forme une diode avec le caisson,
le capteur étant muni d'au moins un pixel intégrant un transistor « d'accélération de détection », ce transistor ayant une grille agencée sur la face supérieure du substrat et qui est connectée au nœud de détection.

Le transistor « d'accélération de détection » peut être configuré pour, lors d'une opération de « détection de débordement de charges » lors de laquelle une barrière de potentiel est maintenue par polarisation de la grille de transfert et consécutivement à une illumination de la zone photosensible durant l'opération entrainant un transfert de charges photo-générées de la zone photosensible vers le nœud de détection et une variation de potentiel à ce nœud de détection, être rendu passant, le transistor « d'accélération de détection » rendu passant affaiblissant la barrière de potentiel et favorisant un transfert de charges photo-générées vers le nœud de détection de la zone photosensible.

Le transistor permet de détecter un débordement le plus rapidement possible tout en limitant la taille du pixel.

Le pixel intégrant le transistor précité permet d'accélérer et amplifier la détection du débordement en provoquant un emballement au niveau de la diode. Cela permet de relâcher les contraintes en termes de gain d'un étage de détection relié au nœud de détection.

Outre cet étage de détection, un circuit de lecture conventionnel peut également être associé au pixel pour la lecture des charges résiduelles.

Le transistor « d'accélération de détection» peut être un transistor de type N, en particulier lorsque la première région et la zone de collecte sont des régions dopées P.

Avantageusement, le transistor « d'accélération de détection» comporte une région de canal formée dans une partie dopée du substrat présentant le premier type de conductivité, en particulier de type P.

Selon une possibilité de mise en œuvre, la région de canal du transistor « d'accélération de détection » s'étend au niveau d'une face supérieure du substrat semi-conducteur entre une zone du caisson formant une région de source du transistor « d'accélération de détection », et une autre zone présentant le deuxième type de conductivité, et formant une région de drain du transistor « d'accélération de détection » .

Selon une possibilité de réalisation, l'autre zone formant la région de drain du transistor présente le deuxième type de conductivité et a un dopage, en particulier de type N+, plus important que le dopage de ladite zone dudit caisson.

Avantageusement, un bloc d'isolation est agencé entre la tranchée d'isolation périphérique et l'autre zone présentant le deuxième type de conductivité et formant la région de drain du transistor.

Selon une possibilité de mise en œuvre, le capteur peut être muni d'un circuit de commande configuré pour, durant l'opération de détection de débordement de charges, appliquer un potentiel sur la grille de transfert durant ladite opération de détection de débordement de charges.

Selon une possibilité de mise en œuvre le circuit de commande est configuré pour, durant l'opération de détection de débordement de charges :
selon une première phase appliquer à la grille du transistor « d'accélération de détection », un premier potentiel d'initialisation de sorte à maintenir le transistor bloqué puis,
selon une deuxième phase, mettre en haute impédance, le nœud de détection et la grille du transistor « d'accélération de détection ».

Le circuit de commande peut être en outre configuré pour,
lors de la première phase : appliquer à une région de source du transistor « d'accélération de détection» un deuxième potentiel d'initialisation de préférence inférieur à un potentiel donné appliqué à une région de drain du transistor « d'accélération de détection» puis,
lors de ladite deuxième phase : mettre en haute impédance la zone du caisson formant la région de source du transistor « d'accélération de détection » tout en maintenant le potentiel donné sur l'autre zone formant la région de drain.

Le circuit de commande peut être configuré pour, consécutivement à la variation de potentiel sur le nœud de détection, remettre le nœud de détection au premier potentiel d'initialisation et la zone dudit caisson au deuxième potentiel d'initialisation.

Selon une possibilité de mise en œuvre, le circuit de commande peut être doté :
- d'un premier étage, en particulier doté d'au moins une porte réalisant une fonction logique « NON OU », comprenant une première entrée prévue pour recevoir un signal de déclenchement de démarrage d'opération de détection et une deuxième entrée couplée au nœud de détection et à la grille transistor « d'accélération de détection »,
- un premier interrupteur de couplage commandé par le signal de sortie du premier étage et qui est prévu pour, lorsqu'il est rendu passant à coupler le nœud de détection à un premier potentiel d'initialisation et lorsqu'il est rendu bloqué à mettre le nœud de détection en haute impédance,
- un deuxième interrupteur de couplage commandé par un signal de sortie du premier étage et qui est prévu pour, lorsqu'il est rendu passant, coupler le caisson à un deuxième potentiel d'initialisation et lorsqu'il est rendu bloqué à mettre le caisson en haute impédance.

Le transistor « d'accélération de détection » peut appartenir à un circuit indicateur de débordement de charges formé d'un étage indicateur, en particulier muni d'un comparateur ou d'une porte logique, telle qu'une porte logique réalisant une fonction « OUI » ou une fonction « NON », configuré pour, consécutivement à la variation du potentiel sur le nœud de détection, produire un signal indicateur de débordement.

Avantageusement, le circuit indicateur de débordement peut être associé à un compteur configuré pour s'incrémenter à chaque réception dudit signal indicateur de débordement.

Selon une mise en œuvre particulière du capteur, les pixels sont agencés dans un niveau N₁ donné d'un dispositif comportant plusieurs niveaux superposés de composants et dans lequel le circuit de commande est agencé dans un autre niveau N₂ du dispositif, distinct dudit niveau donné ledit niveau donné et ledit autre niveau étant superposés.

Selon un autre aspect, la présente invention concerne un dispositif de capture d'images à temps de vol comprenant un capteur d'images tel que défini plus haut.

Selon un autre aspect, la présente invention concerne un dispositif de capture d'images basé sur la détection d'évènements comprenant un capteur d'images tel que défini plus haut.

### BRÈVE DESCRIPTION DES DESSINS

La présente invention sera mieux comprise sur la base de la description qui va suivre et des dessins en annexe sur lesquels :
La figure 1 est une vue en coupe, schématique et partielle, d'un pixel de capteur d'image associé à un transistor permettant accélérer une détection d'un débordement de charges vers le nœud de détection.
La figure 2 est une vue de dessus, schématique et partielle, d'un autre agencement du pixel de capteur d'image associé au transistor d'accélération de détection de débordement de charges.
La figure 3 est une vue en perspective, schématique et partielle, d'un autre agencement du pixel de capteur d'image associé au transistor d'accélération de détection de débordement de charges.
La figure 4 donne des courbes d'évolution du potentiel au sein d'un pixel avant et après exposition de ce dernier.
La figure 5 donne des courbes d'évolution de signaux et potentiel au sein d'un pixel lors d'une opération de détection de débordement de charges.
La figure 6 sert à illustrer un circuit de commande de polarisation du pixel lors d'une opération de détection débordement de charges ainsi qu'un étage de détection de débordement.
La figure 7 est un chronogramme de différents signaux susceptibles d'être mis en œuvre dans le circuit de commande du pixel lors d'une opération de détection de débordement de charges.
La figure 8 sert à illustrer un exemple de réalisation particulier du capteur sur plusieurs niveaux superposés de composants actifs, le pixel et son circuit de commande étant agencés sur des niveaux distincts.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

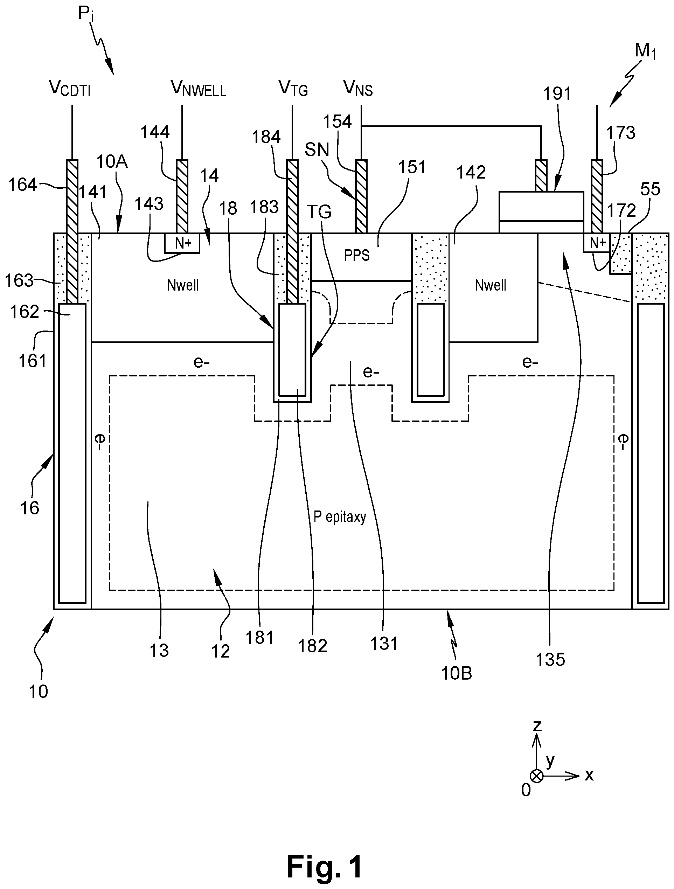

On se réfère à présent à la figure 1 donnant, de manière schématique et partielle et selon une vue en coupe, un agencement de pixel Pi à vitesse de détection de débordement de charges ou de dépassement de seuil de charges amélioré.

Le pixel Pi appartient à un imageur doté typiquement d'une pluralité de pixels identiques au pixel Pi et en particulier agencés en matrice. Dans l'exemple représenté, le pixel Pi comporte une zone photosensible 12 destinée à collecter des photons, lors de phases d'exposition du capteur d'images à au moins un rayonnement lumineux encore appelées « illumination » dont fait partie le pixel Pi, et à convertir ces photons en paires électron-trou. La zone photosensible 12 est formée dans un substrat 10 semi-conducteur.

Ce substrat 10 peut être par exemple à base de silicium et comporte une première région 13 en matériau semi-conducteur dopé d'un premier type de conductivité, par exemple selon un dopage de type P. La première région dopée 13 s'étend notamment dans une portion inférieure ainsi que dans une portion centrale 131 supérieure de ce pixel Pi. Le substrat 10 présente par exemple, à l'endroit de la première région dopée 13, une concentration en dopants comprise entre 1^{e}14 cm⁻³ et 1^{e}17 cm⁻³ atomes/cm³.

La zone photosensible 12 est par exemple destinée à être illuminée depuis une face arrière 10B du substrat 10. Bien que cela ne soit pas représenté en figure 1, la face arrière 10B du substrat 10, opposée à sa face avant 10A peut être revêtue d'une ou de plusieurs couches de passivation. Du côté de la face arrière 10B du substrat 10, le pixel Pi peut en outre comporter des éléments optiques tels qu'un filtre et/ou une microlentille.

Le pixel Pi est délimité et séparé de pixels voisins par une tranchée 16 dite « d'isolation périphérique » formée autour de la zone photosensible 12. La tranchée d'isolation 16 peut entourer entièrement la zone photosensible 12 de sorte à former un contour fermé permettant de complètement isoler électriquement la zone photosensible 12 du pixel Pi par rapport aux zones photosensibles de pixels voisins. A titre d'exemple de réalisation particulier on peut prévoir une tranchée 16 de largeur (dimension mesurée parallèlement au plan [O ; x ; y] d'un repère orthogonal [O ; x ; y ; z]) de l'ordre de 160 nm.

En variante, on peut également prévoir une tranchée d'isolation périphérique 16 réalisant un contour partiel typiquement sous forme d'une succession de portions définissant entièrement au moins les deux côtés ou trois côtés successifs d'un périmètre rectangulaire tandis qu'une partie de ce périmètre, par exemple une partie d'un côté ou d'un angle du rectangle est ouverte et ne comporte pas de tranchée d'isolation.

La tranchée 16 d'isolation périphérique est en particulier une tranchée d'isolation capacitive, typiquement dotée d'une structure de type CDTI (« Capacitive Deep Trench Isolation ») et s'étend verticalement dans l'épaisseur (dimension mesurée parallèlement à l'axe z du repère orthogonal [O ;x ;y ;z] sur la figure 1) du substrat 10. La tranchée 16 est dans ce cas tapissée, au fond et sur ses parois latérales, d'au moins une couche isolante 161, par exemple d'oxyde de silicium (SiO₂) et remplie d'un matériau conducteur 162, par exemple du polysilicium fortement dopé. Le matériau conducteur 162 est relié à un contact 164 pour être polarisé à un potentiel VCDTI. À titre d'exemple, dans le cas où le substrat 10 est de type P, la région conductrice de la tranchée d'isolation périphérique 16 peut être portée à un potentiel VCDTI fixe, par exemple de l'ordre de 2,5 V.

Dans l'exemple de réalisation particulier donné sur la figure 1, le matériau conducteur 162 de la structure CDTI est enfoui et ne s'étend que sur une portion de l'épaisseur du substrat 10 entre la face avant 10A et la face arrière 10B. Ainsi, la partie supérieure de la tranchée 16 n'est pas remplie par le matériau conducteur 162, mais comporte ici un bloc isolant 163, typiquement en oxyde de silicium traversé par un contact 164, typiquement métallique, par exemple en tungstène. Un agencement où le matériau conducteur 162 s'étend complètement à travers l'épaisseur du substrat 10 jusqu'en face avant 10A peut être en variante prévu.

Le pixel Pi comporte en outre une grille de transfert verticale TG formée dans le substrat semi-conducteur 10. La grille de transfert verticale TG est disposée à l'intérieur de la partie du substrat 10 délimitée par la tranchée d'isolation périphérique 16.

La grille de transfert verticale TG est formée dans une autre tranchée d'isolation 18 agencée verticalement dans l'épaisseur du substrat 10. Cette autre tranchée 18 s'étend typiquement entre la face supérieure 10A et une profondeur inférieure à celle de la tranchée d'isolation périphérique 16. La grille de transfert verticale TG a ainsi typiquement une hauteur inférieure à celle de la structure CDTI. A titre d'exemple de réalisation particulier on peut prévoir une tranchée 18 de largeur (dimension mesurée parallèlement au plan [O ; x ; y] d'un repère orthogonal [O ; x ; y ; z]) de l'ordre de 180 nm. L'autre tranchée 18 s'interrompt dans l'épaisseur du substrat 10 et ne débouche pas du côté de la face inférieure 10B du substrat 10.

L'autre tranchée 18 est ici tapissée au fond et sur ses parois latérales d'au moins une couche diélectrique 181, par exemple d'oxyde de silicium (SiO₂) et est remplie d'un matériau conducteur 182, par exemple du polysilicium fortement dopé. Le matériau conducteur 182 est relié à un contact 184 pour polariser la grille de transfert.

Dans l'exemple de réalisation particulier donné sur la figure 1, le matériau conducteur 182 est enfoui. Ainsi, la partie supérieure de la tranchée 18 n'est pas remplie par le matériau conducteur 182, mais comporte ici un bloc isolant 183, typiquement en oxyde de silicium traversé par un contact 184, typiquement métallique, par exemple en tungstène. Un agencement alternatif où le matériau conducteur 182 s'étend jusqu'en face avant 10A peut être en variante prévue.

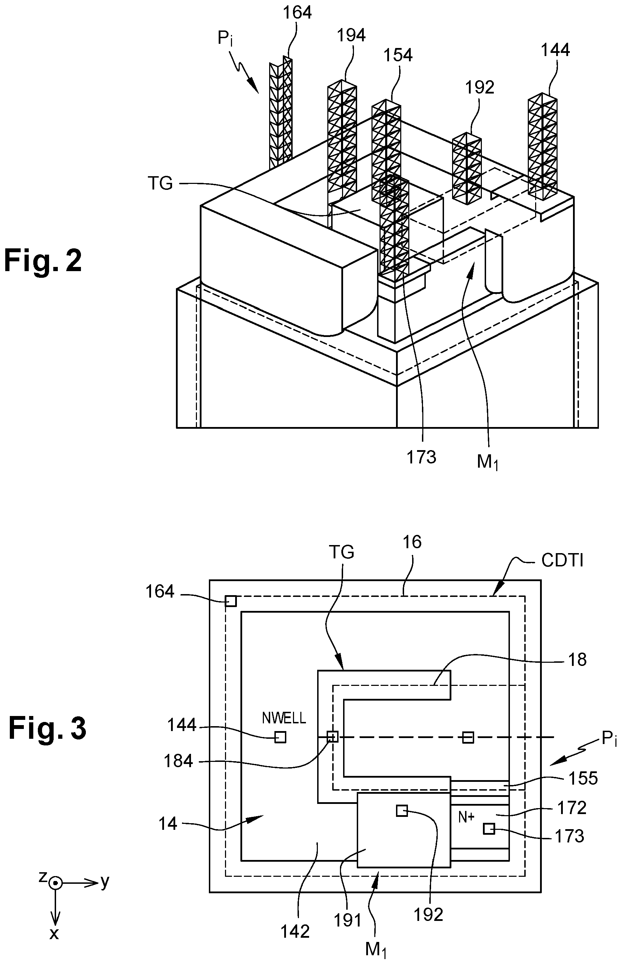

Dans l'exemple de réalisation illustré sur la figure 2 (donnant une vue de dessus d'un agencement particulier du pixel Pi), l'autre tranchée 18 réalise un contour partiel, en particulier en forme de 'C' ou de 'U' autour d'une portion centrale et supérieure du substrat 10.

En variante, et comme illustré dans l'exemple d'agencement de la figure 3 (donnant une vue en perspective d'un autre agencement particulier du pixel Pi), la grille de transfert TG entoure entièrement une portion centrale et supérieure du substrat sur laquelle un nœud de détection SN est prévu.

Durant une exposition du pixel Pi, la grille de transfert TG est polarisée de sorte à former une barrière de potentiel entre la zone photosensible 12 et une portion 131 bordée par cette grille de transfert verticale TG. À titre d'exemple, dans le cas où le substrat 10 est de type P, la région conductrice de l'autre tranchée 18 peut être portée à un potentiel VTG, par exemple de l'ordre de 1,5 V pour imposer la barrière de potentiel.

La présence de la barrière de potentiel permet, au cours d'une phase d'exposition, de bloquer un transfert de trous photo-générés depuis la zone photosensible 12 vers une zone dite « de collecte » 151. Cette barrière de potentiel résulte de la présence, le long de parois latérales de l'autre tranchée d'isolation 18, d'une couche d'inversion attirant les porteurs de type opposé au substrat 10, c'est-à-dire les électrons, lorsque la portion 131 est dopée selon le premier type de conductivité, ici selon un dopage P.

Lors d'une phase de lecture conventionnelle postérieure à la phase d'exposition, la grille de transfert TG est ensuite portée à un potentiel distinct afin d'abaisser, voire de supprimer, la barrière de potentiel. La disparition de la barrière de potentiel permet, pendant la phase de lecture conventionnelle, un transfert de trous photo-générés depuis la zone photosensible 12 vers la zone de collecte 151.

Dans l'exemple représenté sur la figure 1, une portion 131 de la région dopée 13 selon le premier type de conductivité est située à l'intérieur d'un espace délimité par la grille de transfert verticale TG, et en particulier par les parois latérales internes de la grille de transfert verticale TG.

Au-dessus de cette portion 131, se trouve la zone 151 dite « de collecte de charges », également dopée selon le premier type de conductivité, et qui sert à former un nœud de détection SN. Le nœud de détection SN permet par exemple de transférer des charges accumulées dans la zone 151 vers un circuit de lecture ou un étage de détection de débordement de charges.

La zone 151 de collecte s'étend dans l'épaisseur du substrat 10, depuis sa face supérieure 10A, et est bordée par l'autre tranchée d'isolation 18. La portion 131 de collecte est typiquement plus fortement dopée, dans cet exemple P+, que la portion 131 située au-dessous. Le nœud de détection SN est également formé d'un élément conducteur 154, typiquement sous forme d'un plot métallique situé sur et en contact avec la zone 151 de collecte.

Le pixel Pi comporte également un caisson 14 intercalé entre la tranchée d'isolation périphérique 16 d'accueil de la structure CDTI et l'autre tranchée 18 dans laquelle la structure de grille de transfert verticale TG est formée. Le caisson 14 s'étend dans l'épaisseur du substrat 10 et en particulier dans sa partie supérieure, depuis la face supérieure 10A supérieure de ce dernier.

Le caisson 14 est dopé et présente un deuxième type de conductivité opposé au premier type de conductivité. Dans cet exemple, le caisson 14 est ainsi dopé N lorsque la zone 13 est dopée P. Le caisson 14 comporte une première partie 141 dans laquelle il s'étend latéralement depuis la tranchée 16 dans laquelle la structure CDTI est réalisée jusqu'à l'autre tranchée 18 dans laquelle la structure de grille de transfert TG verticale est formée.

Dans l'exemple représenté, un plot conducteur 144, est situé sur et en contact avec une région 143 dopée du deuxième type de conductivité, plus fortement que le reste du caisson 14.

Dans cet exemple, la région 143 peut être dopée N+ lorsque le reste du caisson 114 est dopé N. Le plot conducteur 128 permet par exemple de fournir un potentiel V_{NWELL} au caisson 14.

Avec le pixel Pi, on peut réaliser également une détection particulière distincte d'une succession de phase d'exposition et de lecture conventionnelles.

Lors de cette opération de détection particulière dite « détection de débordement de charges », la grille de transfert TG peut être maintenue à un même potentiel fixe. On détecte alors, suite à une illumination du pixel Pi lorsque le potentiel interne d'une diode (i.e. le potentiel de la zone photosensible 12) dépasse celui d'une barrière de potentiel mise en œuvre par la polarisation de grille TG, de sorte que des charges photo-générées suite à cette illumination, en particulier des trous, débordent de la zone photosensible 12 vers la zone de collecte 151, malgré la barrière de potentiel appliquée sur la grille de transfert TG. La diode est ici formée par la première région 13 dopée du premier type de conductivité, par exemple dopée P et un caisson 14 de dopage opposé et du deuxième type de conductivité, par exemple dopée N.

Un circuit de détection doté par exemple d'un comparateur connecté au nœud de détection SN peut être pour cela prévu et configuré pour émettre un signal indicateur de débordement consécutivement à une variation de potentiel au nœud de détection due à un débordement de charges tandis que la grille de transfert est polarisée de manière à maintenir une barrière de potentiel.

Un moyen pour ajuster la quantité de charges correspondant au seuil de déclenchement ou de débordement est d'ajuster le potentiel de polarisation V_{TG} que l'on applique à la grille de transfert TG.

De manière avantageuse, le pixel Pi a ici pour particularité d'intégrer un transistor M1 dit « d'accélération de détection », permettant de rendre plus rapide une détection du débordement de charges par le nœud de détection SN évoqué précédemment. Le transistor M1 peut également permettre par emballement, d'amplifier la détection d'un débordement de charges. Il peut donc permettre également d'opérer une détection avec un seuil de détection réduit.

Ce transistor M1 a une grille 191 agencée sur la face supérieure 10A du substrat et qui est connectée au nœud de détection SN.

Le transistor M1 est dans cet exemple un transistor de type N, en particulier lorsque la région 13 et la zone de collecte 151 du nœud de détection SN ont un dopage de type P et sont destinées à collecter des charges sous forme de trous photo-générés.

Le transistor M1 a une région de canal formée dans une partie 135 dopée du substrat 10 présentant le premier type de conductivité, en particulier de type P.

Ainsi, le caisson 14 peut comporter une zone 142 qui, contrairement à la partie 141, ne s'étend pas entièrement latéralement depuis la tranchée 16 (dans laquelle la structure CDTI est agencée) jusqu'à l'autre tranchée 18 (dans laquelle la structure de grille de transfert TG verticale est formée). Le caisson 14 dopé selon le deuxième type de conductivité, est ainsi interrompu dans une zone supérieure du substrat 10 dans laquelle la région dopée 13 selon le premier type de conductivité s'étend, une partie 135 de cette région dopée 13 atteignant la face 10A supérieure du substrat 10.

Avantageusement, la région de source du transistor M₁ est formée dans la zone 142 du caisson 14. Dans ce cas, le caisson 14 et la région de source du transistor M1 ont une polarisation identique imposée par le biais du plot conducteur 144.

Le transistor M1 comporte une région de drain formée dans une zone 172 dopée et présentant le deuxième type de conductivité. Cette zone, par exemple de type N+, est typiquement dopée plus fortement que la zone 142 du caisson 14. Afin d'éviter un court-circuit, on peut ici prévoir une zone isolante 155 par exemple de type STI entre la zone active et la zone de drain 172 dans cet exemple dopée.

Pour permettre d'isoler le transistor M1 de la structure CDTI, un bloc d'isolation 55 par exemple en oxyde de silicium (SiO₂) peut être prévu avantageusement entre le transistor M1 et la tranchée 16. Dans l'exemple de réalisation illustré sur la figure 1, ce bloc 55 est situé entre la zone 172 présentant le deuxième type de conductivité formant la région de drain du transistor M1 et la tranchée d'isolation 16 périphérique.

Durant une opération de détection de débordement de charges, la polarisation suivante peut être adoptée :
- un potentiel VCDTI fixe est typiquement appliqué sur le contact 164 pour polariser la structure CDTI, ce potentiel VCDTI pouvant être, selon un exemple de réalisation particulier, de l'ordre de 2.5V ;
- un potentiel VTG fixe est maintenu sur le contact 164 pour polariser la structure CDTI, ce potentiel VTG pouvant être selon un exemple de réalisation particulier de l'ordre de 1.5V ;
- selon une première phase, un potentiel d'initialisation Vinit_SN est appliqué au nœud de détection SN, par exemple de l'ordre de 0V par le biais de l'élément conducteur 154 puis selon une deuxième phase de l'opération de détection de débordement, l'élément conducteur 154 est laissé flottant ou en haute impédance ;
- selon une première phase, un potentiel d'initialisation du caisson 14 Vinit_NWELL, par exemple de l'ordre de 1.3V est appliqué sur le plot conducteur 144 de polarisation du caisson puis selon une deuxième phase de l'opération de détection de débordement, le plot conducteur 144 est laissé flottant ou en haute impédance ;

Consécutivement à la détection d'un débordement de charges par variation du potentiel au nœud de détection SN, on applique à nouveau le potentiel d'initialisation Vinit_NWELL au caisson 14 et le potentiel d'initialisation Vinit_SN au nœud de détection. Le pixel Pi est alors prêt pour effectuer une nouvelle détection de débordement de charges.

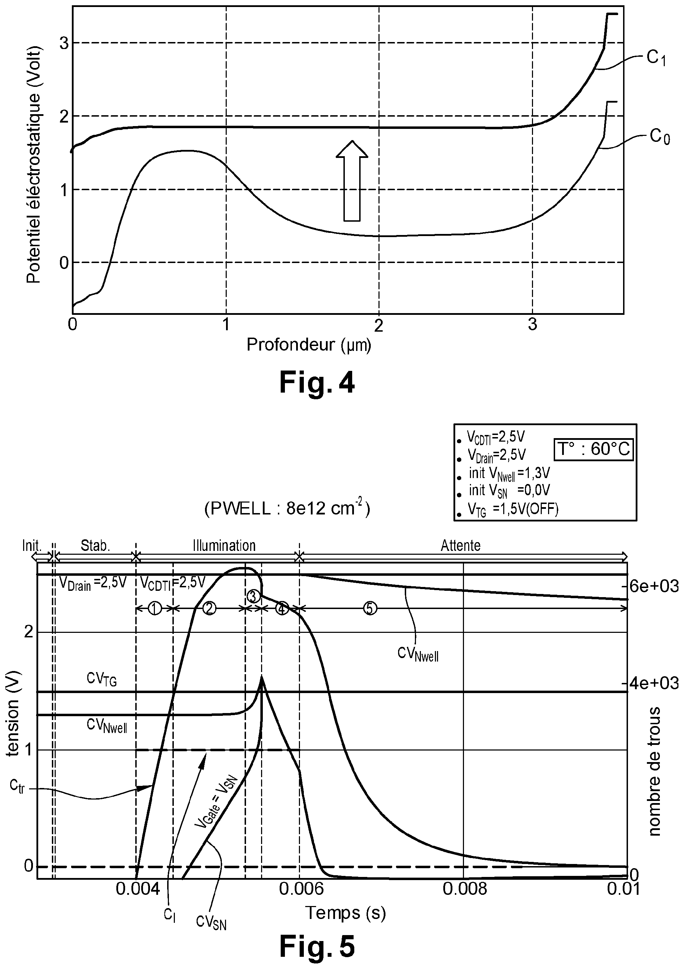

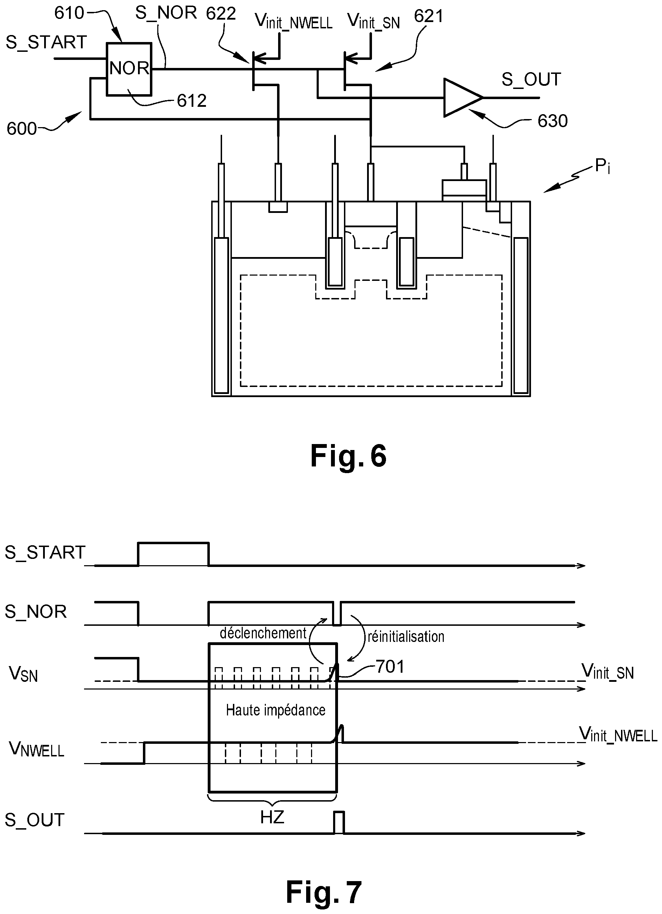

Un mode de fonctionnement du pixel Pi intégrant le transistor M1 lors d'une opération de détection de débordement va à présent être décrit en liaison avec les figures 5 et 6.

Sur la figure 4, une évolution possible du potentiel interne de la diode est donné en fonction de la profondeur à laquelle on se situe dans le substrat 10 avant illumination (courbe C₀) et après illumination (courbe C₁)

La figure 5 donne des courbes résultant d'une simulation d'opération de détection de débordement réalisée par illumination au moyen d'un rayonnement à une longueur d'onde de λ de l'ordre de 450 nm à une température de l'ordre de 60°C.

Tout au long de l'opération de détection débordement on maintient un potentiel fixe (courbe CVTG) par exemple de l'ordre de 2.5 V sur la grille TG.

Lorsque le pixel Pi est illuminé (courbe C_{I} en traits discontinus), la région 13 se remplit de charges positives (courbe Ctr qui augmente).

Si le potentiel interne de la diode formée par la région 13 et le caisson 14, qui évolue en fonction de la quantité de charges photo-générées, devient supérieur au potentiel de la barrière imposé par la grille de transfert TG et qui constitue un seuil de débordement, des charges débordent vers la zone de collecte 151 du nœud de détection SN.

Cela provoque une montée du potentiel (courbe CV_{SN} qui croit) du nœud de détection SN, lequel est relié à la grille du transistor M1 de type NMOS. Le transistor M1 est alors rendu passant.

Lorsque le canal du transistor M1 commence à conduire, le potentiel du caisson 14 correspondant ici au potentiel de la région de source rejoint la tension Vdrain appliqué sur la région de drain. Cette tension Vdrain est typiquement une tension plus forte que celle de la région de source du transistor M1. Cela participe à l'affaiblissement de la couche d'inversion, et favorise le passage des charges vers le nœud de détection SN. La barrière de potentiel présente entre les portions de la grille TG est affaiblie.

La zone photosensible 12 se vide, et on peut détecter un débordement de charges simplement par détection d'une variation, en particulier une montée rapide, du potentiel sur le nœud de détection SN.

Pour cela, le nœud de détection SN peut être relié, comme dans l'exemple de réalisation particulier illustré sur la figure 6, à un étage 630 muni d'un comparateur pour générer un signal S_OUT indicateur de débordement. Une porte logique réalisant une fonction « OUI » ou en variante un porte logique réalisant une fonction « NON » peut être également utilisée pour réaliser cet étage.

Sur cette figure, le pixel Pi est associé à un circuit de commande 600, permettant d'appliquer différents signaux de polarisation au pixel Pi durant l'opération de détection de débordement et de réinitialiser le pixel Pi une fois qu'une opération de détection de débordement est réalisée afin de le rendre prêt à effecteur une nouvelle opération de détection de débordement.

Le circuit de commande 600 est doté d'un premier étage 610, en particulier doté d'une porte 612 réalisant une fonction logique « NON OU », comprenant une première entrée apte à recevoir un signal S_START de déclenchement de démarrage d'opération de détection de débordement.

Une deuxième entrée de la porte 612 est quant à elle reliée au nœud de détection SN lui-même relié à la grille du transistor M1.

Le circuit de commande 600 peut être pourvu en outre d'un premier interrupteur de couplage, ici un premier transistor 621, par exemple de type PMOS. Le premier transistor 621 dont la grille est commandée par le signal de sortie S_NOR du premier étage 610 est prévu pour, lorsqu'il est rendu passant, coupler le nœud de détection SN à un premier potentiel d'initialisation Vinit_SN et lorsqu'il est rendu bloqué, pour mettre le nœud de détection SN en haute impédance.

Le circuit de commande 600 peut être doté également d'un deuxième interrupteur de couplage, en particulier un deuxième transistor 622, par exemple de type PMOS. La grille du transistor 622 est commandée par le signal de sortie S_NOR. Le transistor 622 est prévu pour, lorsqu'il est rendu passant, coupler le caisson 14 à un potentiel d'initialisation Vinit_NWELL et lorsqu'il est rendu bloqué, pour mettre le caisson 14 en haute impédance.

Un exemple de chronogramme de fonctionnement d'un tel circuit 600 est donné sur la figure 7.

L'opération de détection de débordement est initialisée. Cela se traduit par un changement d'état du signal S_START de déclenchement délivré en entrée de l'étage 610. Cela entraine un changement d'état du signal S_NOR produit par la porte 612 réalisant une fonction NOR (NON OU), lequel changement d'état rend passant les transistors 621 et 622. Les potentiels d'initialisation Vinit_NWELL et Vinit_SN sont alors appliqués respectivement au caisson 14 et nœud de détection SN.

Puis, selon une phase de fonctionnement subséquente entrainée par un changement d'état du signal S_START de déclenchement, le signal S_NOR est modifié de sorte à désactiver les transistors 621 et 622. Le caisson 14 et le nœud de détection SN sont alors mis dans un état de haute impédance HZ. Une illumination entrainant un débordement de charges génère une variation de potentiel sur le nœud de détection SN qui se traduit par exemple par un pic 701 de potentiel sur la figure 7. L'étage 630 délivre alors un signal (changement d'état du signal S_OUT) indicateur de débordement.

Le nœud de détection SN étant connecté à l'entrée de la porte NOR 612, cette variation (pic 701) entraine un changement d'état du signal S_NOR qui rend à nouveau passant les transistors 621 et 622 et permet ainsi d'initialiser à nouveau le caisson 14 et le nœud de détection SN respectivement au potentiel Vinit_NWELL et au potentiel Vinit_SN. Le pixel Pi est alors prêt à pouvoir réaliser une nouvelle détection de débordement de charges.

Le signal S_OUT indicateur de débordement peut être un signal logique.

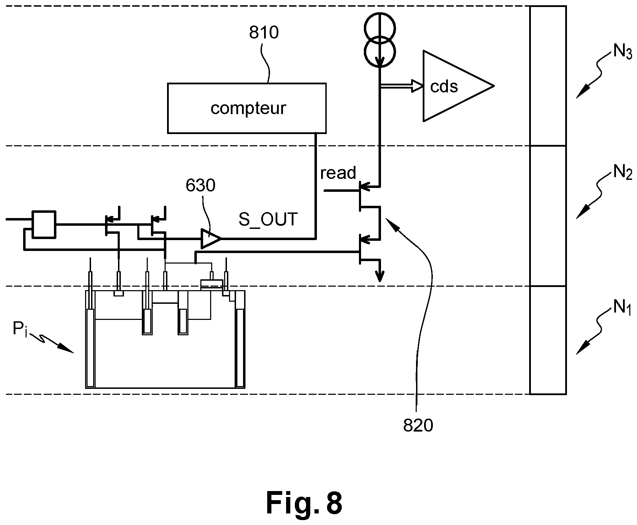

Selon un mode de réalisation avantageux, on peut utiliser ce signal S_OUT pour incrémenter un compteur et réaliser un comptage de nombre de débordements. Ainsi dans l'exemple de réalisation particulier illustré sur la figure 8, l'étage 630 indicateur est associé à un compteur 810 configuré pour s'incrémenter à chaque réception ou changement d'état du signal S_OUT indicateur de débordement. On peut réaliser ainsi un comptage d'évènements, chaque évènement correspondant ici à une détection de débordement. A l'échelle de l'imageur une observation des différents pixels qui détectent un débordement peut être mise en œuvre.

Dans l'exemple de réalisation particulier illustré sur la figure 8, le pixel Pi est situé dans un premier niveau N1 de circuit d'un dispositif comportant plusieurs niveaux superposés N1, N2, N3. Le circuit de commande 600 permettant d'appliquer différents signaux de polarisation au pixel Pi, ainsi que l'étage 630 indicateur de débordement sont ici situés dans un deuxième niveau N2 au-dessus du premier niveau N1. Un circuit de lecture 820 pour permettre une lecture conventionnelle d'une quantité de charges issue du nœud de détection SN peut être également agencé dans le deuxième niveau N2. Dans l'exemple de configuration illustré, le compteur 810 est ici situé sur un troisième niveau N3, sur lequel se trouve un circuit à double échantillonnage corrélé CDS pour (« correlated double sampling »). Les niveaux N1, N2, N3 de composants ou de circuits peuvent être superposés et liés entre eux par une technique d'assemblage communément appelée « d'hybridation ».

Un pixel à détection de débordement de charges tel que décrit précédemment peut trouver de multiples applications et être intégré à un dispositif à réinitialisation automatique multiple de pixel tel que décrit dans le document « Realization and opto-electronic Characterization of linear Self-Reset Pixel Cells for a high dynamic CMOS Image Sensor », de Hirsch et al., Adv. Radio Sci., 17, 239-247, 2019.

Le pixel à détection rapide de débordement peut être également intégré à un dispositif utilisant des compteurs en bord de matrice, et en particulier des compteurs de photons tels qu'utilisés dans certains systèmes SPAD (SPAD pour « Single-Photon Avalanche Diode ») et en particulier dans un système tel que décrit par exemple dans le document : « 7.5 A 250fps 124dB Dynamic-Range SPAD Image Sensor Stacked with Pixel-Parallel Photon Counter Employing Sub-Frame Extrapolating Architecture for Motion Artifact Suppression », J. Ogi, et al., 2021, IEEE International Solid- State Circuits Conference (ISSCC).

Le pixel à détection rapide de débordement peut être également intégré à un dispositif d'imagerie à détection d'évènements du type tel que par exemple celui décrit dans le document « 5.10 A 1280×720 Back-Illuminated Stacked Temporal Contrast Event-Based Vision Sensor with 4.86µm Pixels, 1.066GEPS Readout, Programmable Event-Rate Controller and Compressive Data-Formatting Pipeline », de Thomas Finateu et al., 2020 IEEE International Solid- State Circuits Conference - (ISSCC) ou dans le document : « A 1280×960 Dynamic Vision Sensor with a 4.95-µm Pixel Pitch and Motion Artifact Minimization », de Yunjae Suh et al., IEEE International Symposium on Circuits and Systems (ISCAS), 2020, ou dans le document : « Development of Event-based Sensor and Applications », Shoushun Chen, OmniVision, 2020.

Dans le cas où une détection de débordement très rapide est mise en œuvre, et que la quantité de charges détectée est limitée, on peut prévoir d'intégrer un pixel à détection rapide de débordement de charges tel que décrit précédemment dans un imageur configuré pour effectuer des mesures de distance sur une scène, en utilisant le temps écoulé entre l'émission par une source émettrice d'un rayonnement lumineux et l'instant où le débordement de pixel est détecté suite à la réception par l'imageur de ce rayonnement.

Un tel dispositif peut être alors pourvu en outre d'un compteur dit TDC (« Time to Digital Counter ») pour l'estimation temporelle de l'arrivée des photons.

## Revendications

1. Capteur d'images comprenant un ou plusieurs pixels, chaque pixel (Pi) comportant :
- une zone photosensible (12) formée dans un substrat (10) semi-conducteur ;
- une tranchée d'isolation périphérique (16) s'étendant verticalement dans le substrat semi-conducteur et délimitant latéralement la zone photosensible (12) ;
- un nœud de détection (SN) comportant une zone (151) de collecte de charges photo-générées agencée au niveau d'une face supérieure (10A) du substrat (10), la zone (110) de collecte de charges étant dopée et présentant un premier type de conductivité, en particulier de type P ;
- une grille de transfert (TG) de charges s'étendant verticalement dans le substrat semi-conducteur autour de la zone (151) de collecte de charges ;
- un caisson (14) intercalé entre la tranchée d'isolation périphérique (16) et la grille de transfert verticale (TG), et agencé autour du nœud de détection (SN), le caisson (14) étant dopé et présentant un deuxième type de conductivité, opposé au premier type de conductivité, en particulier de type N, la zone photosensible (12) étant formée d'une première région (13) dopée qui est du premier type de conductivité, en particulier de type P, et qui s'étend sous la zone (151) de collecte de charges et sous le caisson (14) et forme une diode avec le caisson (14),
le capteur étant muni d'au moins un pixel (Pi) intégrant un transistor (M1) dit « d'accélération de détection », ledit transistor (M1) dit « d'accélération de détection » ayant une grille (191) agencée sur ladite face supérieure (10A) du substrat et qui est connectée au nœud de détection (SN), le transistor (M1) « d'accélération de détection » étant configuré pour, lors d'une opération dite de « détection de débordement de charges » lors de laquelle une polarisation de la grille de transfert (TG) est appliquée de sorte à former une barrière de potentiel puis maintenue et consécutivement à une illumination de la zone photosensible (12) durant ladite opération entrainant un transfert de charges photo-générées de la zone photosensible (12) vers le nœud de détection (SN) et une variation de potentiel à ce nœud de détection (SN), être rendu passant, le transistor « d'accélération de détection » rendu passant affaiblissant la barrière de potentiel et favorisant un transfert de charges photo-générées vers le nœud de détection (SN) de la zone photosensible, le transistor (M1) « d'accélération de détection» comportant une région de canal formée dans une partie (135) dopée du substrat (10) présentant le premier type de conductivité et appartenant à ladite première région (13).

2. Capteur d'images selon la revendication 1, dans lequel ladite région de canal du transistor (M1) « d'accélération de détection » s'étend au niveau d'une face supérieure (10A) du substrat semi-conducteur entre une zone (142) dudit caisson (14), formant en particulier une région de source dudit transistor (M1) « d'accélération de détection », et une autre zone (172) présentant le deuxième type de conductivité, et formant en particulier une région de drain dudit transistor (M1) « d'accélération de détection » .

3. Capteur d'images selon la revendication 2, dans lequel ladite autre zone (172) présente le deuxième type de conductivité et a un dopage, en particulier de type N+, plus important que le dopage de ladite zone dudit caisson (114).

4. Capteur d'images selon l'une des revendications 2 ou 3, dans lequel un bloc d'isolation (55) est agencé entre la tranchée d'isolation périphérique (16) et ladite autre zone (172) présentant le deuxième type de conductivité.

5. Capteur d'images selon l'une des revendications 1 à 4, comprenant en outre un circuit de commande (600) configuré pour, durant ladite opération de détection de débordement de charges, appliquer un potentiel (VTG) sur la grille de transfert (TG) de sorte à maintenir ladite barrière de potentiel durant ladite opération de détection de débordement de charges.

6. Capteur d'images selon la revendication 5, dans lequel le circuit de commande (600) est configuré pour, durant ladite opération de détection de débordement de charges :
selon une première phase appliquer à la grille (191) dudit transistor (M1) « d'accélération de détection », un premier potentiel d'initialisation (Vsninit) de sorte à maintenir le transistor (M1) bloqué puis,
selon une deuxième phase, mettre en haute impédance, le nœud de détection (SN) et la grille (191) du transistor (M1) « d'accélération de détection ».

7. Capteur d'images selon la revendication 6 lorsque rattachée à la revendication 2, dans lequel le circuit de commande (600) est configuré pour,
lors de ladite première phase : appliquer à une région de source du transistor (M1) « d'accélération de détection» un deuxième potentiel d'initialisation (VNWELLinit) de préférence inférieur à un potentiel donné (Vdrain) appliqué à une région de drain du transistor (M1) « d'accélération de détection» puis,
lors de ladite deuxième phase : mettre en haute impédance ladite zone (142) dudit caisson (14) tout en maintenant ledit potentiel donné (Vdrain) sur ladite autre zone (172).

8. Capteur d'images selon l'une des revendications 6 ou 7, dans lequel le circuit de commande (600) est configuré pour, consécutivement à ladite variation de potentiel sur le nœud de détection (SN), remettre le nœud de détection (SN), au premier potentiel d'initialisation (Vinit_SN) et ladite zone (142) dudit caisson (14) au deuxième potentiel d'initialisation (Vinit_NWELL).

9. Capteur d'images selon l'une des revendications 5 à 8, dans lequel le circuit de commande (600) est doté :
- d'un premier étage (610), en particulier doté d'au moins une porte (612) réalisant une fonction logique « NON OU », comprenant une première entrée prévue pour recevoir un signal (S_START) de déclenchement de démarrage d'opération de détection et une deuxième entrée couplée au nœud de détection (SN) et à la grille transistor (M1) « d'accélération de détection »,
- un premier interrupteur (621) de couplage commandé par le signal de sortie du premier étage (610) et qui est prévu pour, lorsqu'il est rendu passant à coupler le nœud de détection (SN) à un premier potentiel d'initialisation (Vsninit) et lorsqu'il est rendu bloqué à mettre le nœud de détection (SN) en haute impédance,
- un deuxième interrupteur (622) de couplage commandé par un signal de sortie du premier étage (610) et qui est prévu pour, lorsqu'il est rendu passant, coupler le caisson (14) à un deuxième potentiel d'initialisation (VNWELLinit) et lorsqu'il est rendu bloqué à mettre le caisson (14) en haute impédance.

10. Capteur d'images selon l'une des revendications 5 à 9, dans lequel le transistor (M1) appartient à un circuit indicateur de débordement de charges formé d'un étage indicateur (630), en particulier muni d'un comparateur ou d'une porte logique telle qu'une porte logique réalisant une fonction OUI ou une fonction NON, configuré pour, consécutivement à ladite variation du potentiel sur le nœud de détection (SN), produire un signal (S_OUT) indicateur dudit débordement.

11. Capteur d'images selon la revendication 10, dans lequel le circuit indicateur de débordement est associé à un compteur (810) configuré pour s'incrémenter à chaque réception dudit signal (S_OUT) indicateur de débordement.

12. Capteur d'images selon l'une des revendications 5 à 11, dans lequel les pixels sont agencés dans un niveau (N₁) donné d'un dispositif comportant plusieurs niveaux (N₁, N₂, N₃) superposés de composants et dans lequel le circuit de commande est agencé dans un autre niveau (N₂) du dispositif, distinct dudit niveau donné ledit niveau donné et ledit autre niveau étant superposés.

13. Dispositif de capture d'images à temps de vol comprenant un capteur d'images selon l'une des revendications 1 à 12.

14. Dispositif de capture d'images basé sur la détection d'évènements comprenant un capteur d'images selon l'une des revendications 1 à 12.

## Patentansprüche

1. Bildsensor, der ein oder mehrere Pixel umfasst, jedes Pixel (Pi) umfassend:
- eine lichtempfindliche Zone (12), die in einem Halbleitersubstrat (10) ausgebildet ist;
- einen peripheren Isolationsgraben (16), der sich vertikal in dem Halbleitersubstrat erstreckt und die lichtempfindliche Zone (12) seitlich begrenzt;
- einen Erkennungsknoten (SN) mit einer Zone (151) zum Sammeln von lichtgenerierten Ladungen, die auf der Höhe einer oberen Fläche (10A) des Substrats (10) angeordnet ist, wobei die Zone (110) zum Sammeln von Ladungen dotiert ist und einen ersten Leitfähigkeitstyp, insbesondere vom Typ P, aufweist;
- ein Ladungsübertragungsgitter (TG), das sich vertikal in dem Halbleitersubstrat um die Ladungssammelzone (151) herum erstreckt;
- einen Kasten (14), der zwischen dem peripheren Isolationsgraben (16) und dem vertikalen Transfergitter (TG) angeordnet ist und um den Erkennungsknoten (SN) herum angeordnet ist, wobei der Kasten (14) dotiert ist und einen zweiten Leitfähigkeitstyp aufweist, der dem ersten Leitfähigkeitstyp entgegengesetzt ist, insbesondere vom N-Typ, wobei die lichtempfindliche Zone (12) aus einer ersten dotierten Region (13) gebildet ist, die vom ersten Leitfähigkeitstyp, insbesondere vom P-Typ, ist, und die sich unter der Ladungssammelzone (151) und unter dem Kasten (14) erstreckt und mit dem Kasten (14) eine Diode bildet,
wobei der Sensor mit mindestens einem Pixel (Pi) versehen ist, das einen sogenannten "Erfassungsbeschleunigungstransistor" (M1) integriert, wobei der sogenannte "Erfassungsbeschleunigungstransistor" (M1) ein Gitter (191) aufweist, das auf der oberen Fläche (10A) des Substrats angeordnet ist und das mit dem Erkennungsknoten (SN) verbunden ist, wobei der "Erfassungsbeschleunigungstransistor" (M1) konfiguriert ist, um, bei einem Vorgang, der "Ladungsüberlauferkennung" genannt wird, bei dem eine Vorspannung des Transfergitters (TG) angelegt wird, um eine Potentialbarriere zu bilden, die dann aufrechterhalten wird, und nach einer Beleuchtung der lichtempfindlichen Zone (12) während dieses Vorgangs, die eine Übertragung von photoerzeugten Ladungen der lichtempfindlichen Zone (12) auf den Erkennungsknoten (SN) und eine Potentialänderung an diesem Erkennungsknoten (SN) bewirkt, der "Erkennungsbeschleunigungstransistor", eingeschaltet wird, wobei der eingeschaltete "Erkennungsbeschleunigungstransistor", die Potentialbarriere schwächt und einen Transfer von lichterzeugten Ladungen zum Erkennungsknoten (SN) der lichtempfindlichen Zone fördert, wobei der "Erkennungsbeschleunigungstransistor" (M1) eine Kanalregion aufweist, die in einem dotierten Teil (135) des Substrats (10) gebildet ist, der den ersten Leitfähigkeitstyp aufweist und zu der ersten Region (13) gehört.

2. Bildsensor nach Anspruch 1, wobei sich die Kanalregion des "Erkennenbeschleunigungstransistors (M1)" an einer oberen Fläche (10A) des Halbleitersubstrats zwischen einer Zone (142) des Kastens (14), die insbesondere eine Quellenregion des "Erkennenbeschleunigungstransistors (M1)" bildet, und einer anderen Zone (172), die den zweiten Leitfähigkeitstyp aufweist und insbesondere eine Drainregion des "Erkennenbeschleunigungstransistors (MI)" bildet, erstreckt.

3. Bildsensor nach Anspruch 2, wobei die andere Zone (172) den zweiten Leitfähigkeitstyp aufweist und eine Dotierung, insbesondere vom N+-Typ, aufweist, die größer ist als die Dotierung der Zone des Kastens (114).

4. Bildsensor nach einem der Ansprüche 2 oder 3, wobei ein Isolationsblock (55) zwischen dem Umfangsisolationsgraben (16) und der anderen Zone (172) mit dem zweiten Leitfähigkeitstyp angeordnet ist.

5. Bildsensor nach einem der Ansprüche 1 bis 4, ferner umfassend eine Steuerschaltung {600), die so konfiguriert ist, dass sie während der Erkennung des Ladungsüberlaufs ein Potential (VTG) an das Transfergitter (TG) anlegt, sodass die Potentialbarriere während der Erkennung des Ladungsüberlaufs aufrechterhalten wird.

6. Bildsensor nach Anspruch 5, wobei die Steuerschaltung {600) so konfiguriert ist, dass sie während der Erkennungschaltung des Ladungsüberlaufs Folgendes ausführt:
Anlegen eines ersten Initialisierungspotentials (Vsninit) an das Gitter (191) des Transistors (M1) "zur Beschleunigung des Erkennens" gemäß einer ersten Phase, sodass der Transistor (M1) gesperrt bleibt, dann,
Bringen des Erkennungsknotens (SN) und des Gitters (191) des Transistors (MI) "zur Beschleunigung des Erkennens" in eine hohe Impedanz gemäß einer zweiten Phase.

7. Bildsensor nach Anspruch 6 in Verbindung mit Anspruch 2, wobei die Steuerschaltung {600) konfiguriert ist, um während der ersten Phase: an eine Quellenregion des "Erkennungsbeschleunigungstransistors" (M1) ein zweites Initialisierungspotential (VNWELLinit) anzulegen, das vorzugsweise kleiner ist als ein gegebenes Potential (Vdrain), das an eine Drain-Region des "Erkennungsbeschleunigungstransistors" (MI) angelegt wird, und dann,
in der zweiten Phase: die Zone (142) des Kastens (14) hochohmig zu machen, während das gegebene Potential (Vdrain) an der anderen Zone (172) aufrechterhalten wird.

8. Bildsensor nach einem der Ansprüche 6 oder 7, wobei die Steuerschaltung (600) so konfiguriert ist, dass sie nach der Potenzialänderung am Erkennungsknoten (SN) den Erkennungsknoten (SN) auf das erste Initialisierungspotenzial (Vinit_SN) und die Zone (142) des Kastens (14) auf das zweite Initialisierungspotenzial (Vinit_NWELL) zurücksetzt.

9. Bildsensor nach einem der Ansprüche 5 bis 8, wobei die Steuerschaltung (600) Folgendes aufweist:
- eine erste Stufe (610), die insbesondere mit mindestens einem Gatter (612) versehen ist, das eine logische Funktion "NICHT ODER" realisiert, umfassend eine erste Eingabe, die dazu vorgesehen ist, ein Signal (S_START) zur Auslösung des Starts des Erkennungsvorgangs zu empfangen, und eine zweite Eingabe, die mit dem Erkennungsknoten (SN) und dem Transistorgitter (M1) "zur Beschleunigung des Erkennens" gekoppelt ist,
- einen ersten Kopplungsschalter (621), der durch das Ausgabesignal der ersten Stufe (610) gesteuert wird und der dazu vorgesehen ist, wenn er eingeschaltet wird, den Erkennungsknoten (SN) an ein erstes Initialisierungspotential (Vsninit) zu koppeln, und wenn er ausgeschaltet wird, den Erkennungsknoten (SN) hochohmig zu machen,
- einen zweiten Kopplungsschalter (622), der durch ein Ausgabesignal der ersten Stufe (610) gesteuert wird und der dazu vorgesehen ist, wenn er eingeschaltet ist, den Kasten (14) an ein zweites Initialisierungspotential (VNWELLinit) zu koppeln und wenn er ausgeschaltet ist, den Kasten (14) auf hohe Impedanz zu schalten.

10. Bildsensor nach einem der Ansprüche 5 bis 9, wobei der Transistor (M1) zu einer Ladungsüberlaufindikatorschaltung gehört, die von einer Indikatorstufe (630) gebildet wird, die insbesondere mit einem Komparator oder einem logischen Gitter wie einem logischen Gitter, das eine JA-Funktion oder eine NEIN-Funktion realisiert, versehen ist und so konfiguriert ist, dass sie nach der genannten Änderung des Potenzials am Erkennungsschaltungsknoten (SN) ein Signal (S_OUT) erzeugt, das den genannten Überlauf anzeigt.

11. Bildsensor nach Anspruch 10, wobei die Überlaufindikatorschaltung mit einem Zähler (810) verbunden ist, der so konfiguriert ist, dass er sich bei jedem Empfang des Überlaufindikatorsignals (S_OUT) inkrementiert.

12. Bildsensor nach einem der Ansprüche 5 bis 11, wobei die Pixel in einer gegebenen Ebene (N₁) eines Geräts angeordnet sind, das mehrere übereinanderliegende Ebenen (N₁, N₂, N₃) von Komponenten umfasst, und wobei die Steuerschaltung in einer anderen Ebene (N₂) des Geräts angeordnet ist, die von der gegebenen Ebene verschieden ist, wobei die gegebene Ebene und die andere Ebene übereinanderliegend sind.

13. Gerät zum Erfassen von Flugzeitbildern, umfassend einen Bildsensor nach einem der Ansprüche 1 bis 12.

14. Gerät zur Bilderfassung auf der Grundlage des Erkennens von Ereignissen, umfassend einen Bildsensor nach einem der Ansprüche 1 bis 12.

## Claims

1. An image sensor comprising one or more pixels, each pixel (Pi) including:
- a photosensitive region (12) formed in a semiconductor substrate (10);
- a peripheral isolation trench (16) extending vertically in the semiconductor substrate and laterally delimiting the photosensitive region (12);
- a sense node (SN) including a region (151) for collecting photogenerated charges arranged at a top face (10A) of the substrate (10), the charge-collecting region (110) being doped and having a first conductivity type, in particular p type;
- a charge-transfer gate (TG) extending vertically in the semiconductor substrate around the charge-collecting region (151);
- a well (14) interposed between the peripheral isolation trench (16) and the vertical transfer gate (TG), and arranged around the sense node (SN), the well (14) being doped and having a second conductivity type, opposite to the first conductivity type, in particular n type, the photosensitive region (12) being formed by a first doped region (13) that is of the first conductivity type, in particular p type, and which extends under the charge-collecting region (151) and under the well (14) and forms a diode with the well (14),
the sensor being provided with at least one pixel (Pi) integrating a so-called "detection acceleration" transistor (M1), said so-called "detection acceleration" transistor (M1) having a gate (191) arranged on said top face (10A) of the substrate and which is connected to the sense node (SN), the "detection acceleration" transistor (M1) being configured to, during a so-called "charge overflow detection" operation during which a biasing of the transfer gate (TG) is applied so as to form a potential barrier then maintained and following an illumination of the photosensitive region (12) during said operation causing a transfer of photogenerated charges from the photosensitive region (12) to the sense node (SN) and a variation in potential at this sense node (SN), be switched on, the switched-on "detection acceleration" transistor weakening the potential barrier and favouring a transfer of photogenerated charges to the sense node (SN) of the photosensitive region, the "detection acceleration" transistor (M1) including a channel region formed in a doped part (135) of the substrate (10) having the first conductivity type and belonging to said first region (13).

2. The image sensor according to claim 1, wherein said channel region of the "detection acceleration" transistor (M1) extends at a top face (10A) of the semiconductor substrate between a region (142) of said well (14), forming in particular a source region of said "detection acceleration" transistor (M1), and another region (172) having the second conductivity type, and forming in particular a drain region of said "detection acceleration" transistor (M1).

3. The image sensor according to claim 2, wherein said other region (172) has the second conductivity type and has a doping, in particular of the n+ type, greater than the doping of said region of said well (114).

4. The image sensor according to any of the claims 2 or 3, wherein an isolation block (55) is arranged between the peripheral isolation trench (16) and said other region (172) having the second conductivity type.

5. The image sensor according to any of the claims 1 to 4, further comprising a control circuit (600) configured to apply, during said operation of detecting overflow of charges, a potential (VTG) to the transfer gate (TG) so as to maintain said potential barrier during said operation of detecting overflow of charges.

6. The image sensor according to claim 5, wherein the control circuit (600) is configured to, during said operation of detecting overflow of charges:
in a first phase, apply, to the gate (191) of said "detection acceleration" transistor (M1), a first initialisation potential (Vsninit) (M1) so as to keep the transistor switched off, then
in a second phase, put the sense node (SN) and the gate (191) of the "detection acceleration" transistor (M1) in high impedance.

7. The image sensor according to claim 6 when attached to claim 2, wherein the control circuit (600) is configured to,
in said first phase: apply, to a source region of the "detection acceleration" transistor (M1), a second initialisation potential (VNWELLinit) preferably lower than a given potential (Vdrain) applied to a drain region of the "detection acceleration" transistor (M1), then
in said second phase: put said region (142) of said well (14) at high impedance while maintaining said given potential (Vdrain) on said other region (172).

8. The image sensor according to any of the claims 6 or 7 wherein the control circuit (600) is configured to, following said variation in potential on the sense node (SN), reset the sense node (SN) to the first initialisation potential (Vinit_SN) and said region (142) of said well (14) to the second initialisation potential (Vinit_NWELL).

9. Image sensor according to any of the claims 5 to 8, wherein the control circuit (600) is provided with:
- a first stage (610), in particular provided with at least one gate (612) implementing a "NOR" logic function, comprising a first input designed to receive a signal (S_START) triggering the start of a detection operation and a second input coupled to the sense node (SN) and to the "detection acceleration" transistor gate (M1),
- a first coupling switch (621) controlled by the output signal of the first stage (610) and which is designed to, when it is switched on, couple the sense node (SN) to a first initialisation potential (Vsninit) and, when it is switched off, set the sense node (SN) to high impedance,
- a second coupling switch (622) controlled by an output signal of the first stage (610) and which is designed to, when it is switched on, couple the well (14) to a second initialisation potential (VNWELLinit) and, when it is switched off, to set the well (14) to high impedance.

10. The image sensor according to any of the claims 5 to 9, wherein the transistor (M1) belongs to a circuit indicating charge overflow formed by an indicator stage (630), in particular provided with a comparator or with a logic gate, such as a logic gate fulfilling a "YES" function or a "NO" function, configured to produce, following said variation in potential on the sense node (SN), a signal (S_OUT) indicating said overflow.

11. The image sensor according to claim 10, wherein the overflow indicator circuit is associated with a counter (810) configured to be incremented at each reception of said overflow indicator signal (S_OUT).

12. The image sensor according to any of the claims 5 to 11, wherein the pixels are arranged in a given level (N₁) of a device including a plurality of superimposed levels (N₁, N₂, N₃) of components and wherein the control circuit is arranged in another level (N₂) of the device, distinct from said given level, said given level and said other level being superimposed.

13. A time-of-flight image capture device comprising the image sensor according to any of the claims 1 to 12.

14. An image capture device based on the detection of events, comprising the image sensor according any of the claims 1 to 12.
